Europäisches Patentamt

European Patent Office

Office européen des brevets

(19)

(11) Veröffentlichungsnummer : **0 103 756**
**B1**

# (12) EUROPÄISCHE PATENTSCHRIFT

(45) Veröffentlichungstag der Patentschrift :
01.02.89

(21) Anmeldenummer : 83108175.7

(22) Anmeldetag : 18.08.83

(51) Int. Cl.⁴ : **H 03 H 21/00**

(54) Verfahren zur Einstellung des Koeffizienten eines adaptiven Transversalfilters.

(30) Priorität : 20.08.82 DE 3231047

(43) Veröffentlichungstag der Anmeldung :
28.03.84 Patentblatt 84/13

(45) Bekanntmachung des Hinweises auf die Patenterteilung : 01.02.89 Patentblatt 89/05

(84) Benannte Vertragsstaaten :
AT CH DE GB IT LI

(56) Entgegenhaltungen :
IEEE TRANSACTIONS ON INFORMATION THEORY,
Band IT-17, Nr. 4, July 1971, Seiten 431-439, New
York, US; T.J. SCHONFELD et al.: "A rapidly converging first-order training algorithm for an adaptive
equalizer"
IEE PROCEEDINGS-F, Band 128, Nr. 4, Teil F, August
1981, Seiten 225-230, Old Woking, Surrey, GB; C.F.N.
COWAN et al.: "New digital adaptive-filter implementation using distributed-arithmetic techniques"
1980 INTERNATIONAL ZURICH SEMINAR ON DIGI-
TAL COMMUNICATIONS, PROCEEDINGS, IEEE Catalog Nr. 80CH1521-4 COM, 4.-6. März 1980, Seiten G7.1
- G7.6 Zürich, CH; J. SPEIDEL: "A new automatic
recursive equalizer with improved convergence properties"
IEEE Transactions on Acoustics, Speech and Signal
Processing, vol. A5SP-27, no. 6, December 1979, pp.
768-781

(73) Patentinhaber : **Siemens Aktiengesellschaft Berlin**
**und München**
**Wittelsbacherplatz 2**
**D-8000 München 2 (DE)**

(72) Erfinder : **Müller, Eugen, Dr. Ing.**
**Birgweg 8**
**D-8021 Hohenschäftlarn (DE)**
Erfinder : **Stummer, Baldur, Dipl.-Ing.**
**Wilhelm-Kuhnert-Strasse 21**
**D-8000 München 90 (DE)**

## Beschreibung

Die Erfindung betrifft ein Verfahren zur Einstellung der Koeffizienten eines adaptiven Transversalfilters (durchzuführende Korrekturen) durch Modifikation des Vorzeichenalgorithmus.

Die Einstellung der Koeffizienten $C_v$ eines adaptiven Transversalfilters erfolgt bekanntlich mit Hilfe eines geeigneten Korrekturalgorithmus. Die Größe des sogenannten Korrekturinkrementes $\Delta C_v$ muß unter Beachtung zweier gegenläufiger Tendenzen festgelegt werden. Wählt man $\Delta C_v$ sehr klein, erreicht man eine sehr große Genauigkeit der dargestellten Koeffizienten. Der Sollwert von $C_v$ wird dann im allgemeinen erst nach sehr vielen Korrekturschritten, d. h. nach sehr langer Zeit, erreicht. Für einen großen Wert von $\Delta C_v$ ergibt sich eine kleinere Zahl von Korrekturschritten und somit ein schnelleres Einlaufen der Koeffizienten, doch können die Koeffizienten nur mit reduzierter Genauigkeit dargestellt werden.

Es besteht also der Wunsch, das Korrekturinkrement in seinem Wert veränderlich zu gestalten, ohne komplizierte Korrekturalgorithmen zu verwenden die z. B. die Ermittlung der Gradienten und somit einen großen Schaltungsaufwand erfordern, oder eine A/D-Wandlung (Analog/Digital) verwenden zu müssen und trotzdem den Einlaufvorgang zu beschleunigen. Mit diesem Thema befaßt sich der Aufsatz von N. Verhoeckx et al : « Digital-Echo-Cancellation for Baseband Data Transmission » in IEEE- ASSP-27 (1979) 6, 5, Seiten 768 bis 781, und es ist dort u. a. folgendes ausgeführt.

Verwendet wurden bisher verschiedene Algorithmen, die entweder aufwendig zu realisieren sind (Gradientenverfahren) und ein relativ schnelles Einstellen der Koeffizienten bewirken oder aber bei reduziertem Hardwareaufwand Koeffizientenkorrekturen nur nach längerer Zeit ausführen und somit langsamer die endgültige Einstellung erreichen (Korrelationsalgorithmus). Durch weitere Vereinfachung (Stochastischer Iterationsalgorithmus), Vorzeichenalgorithmus) kann zwar der Schaltungsaufwand durch vereinfachte Multiplikation und entfallende Mittelwertbildung noch weiter reduziert werden, doch resultiert daraus ein vergleichsweise sehr langsamer Einstellvorgang.

Aufgabe der Erfindung ist es deshalb, ein Verfahren zur Einstellung der Koeffizienten für ein adaptives Transversalfilter anzugeben, bei dem mit einem relativ geringen Schaltungsaufwand der Einlauf der Koeffizienten, d. h. die Einstellung des adaptiven Transversalfilters, beschleunigt wird.

Ausgehend von einem Verfahren zur Einstellung der Koeffizienten eines adaptiven Transversalfilters (durchzuführende Korrekturen) durch Modifikation des Vorzeichenalgorithmus, wird diese Aufgabe erfindungsgemäß dadurch gelöst, daß in Abhängigkeit von der Zahl der Korrekturen in einem Auswertezyklus die Größe des Korrekturinkrementes ($\Delta C_v$) variiert wird.

Weitere vorteilhafte Verfahrensausgestaltungen und Schaltungsanordnungen sind in den Unteransprüchen angegeben.

Anhand von Ausführungsbeispielen wird die Erfindung nachstehend noch näher erläutert.

Es zeigen in der Zeichnung

Fig. 1 eine an sich bekannte Schaltung bzw. ein an sich bekanntes Verfahren, bei dem ein Vorzeichenalgorithmus verwendet wird, und zwar ist die Darstellung nur für die Einstellung bzw. die Verarbeitung eines Koeffizienten dargestellt,

Fig. 2 als Anwendungsbeispiel des erfindungsgemäßen Verfahrens eine erfindungsgemäße Schaltung, bei der eine adaptive Einstellung des Inkrementes $\Delta C_v$ in einem Auswertezyklus $k \cdot T_{Bit}$ erfolgt, wobei ebenfalls nur die Verarbeitung eines Koeffizienten dargestellt ist,

Fig. 3 als weiteres Anwendungsbeispiel des erfindungsgemäßen Verfahrens eine weitere erfindungsgemäße Schaltung zur adaptiven Einstellung des Inkrementes $\Delta C_v$, bei der sich der Auswertezyklus über k Korrekturen erstreckt und die wiederum nur die Verarbeitung eines Koeffizienten dargestellt ist,

Fig. 4 den Zeitverlauf des logarithmisch dargestellten normierten Restfehlers u als Ergebnis einer Rechnersimulation ($u = 20 \text{ dB} \cdot \log |U \text{ rest}|/U \text{ Leitung}$), wobei in Fig. 4a der Vorzeichenalgorithmus nach dem bekannten Verfahren in Fig. 4b die Ergebnisse unter Verwendung einer Schaltung nach Fig. 2 bei $T = 32 \cdot T_{bit}$ und in Fig. 4c die Ergebnisse bei Verwendung einer Schaltung nach Fig. 3 bei 32 Korrekturen dargestellt sind.

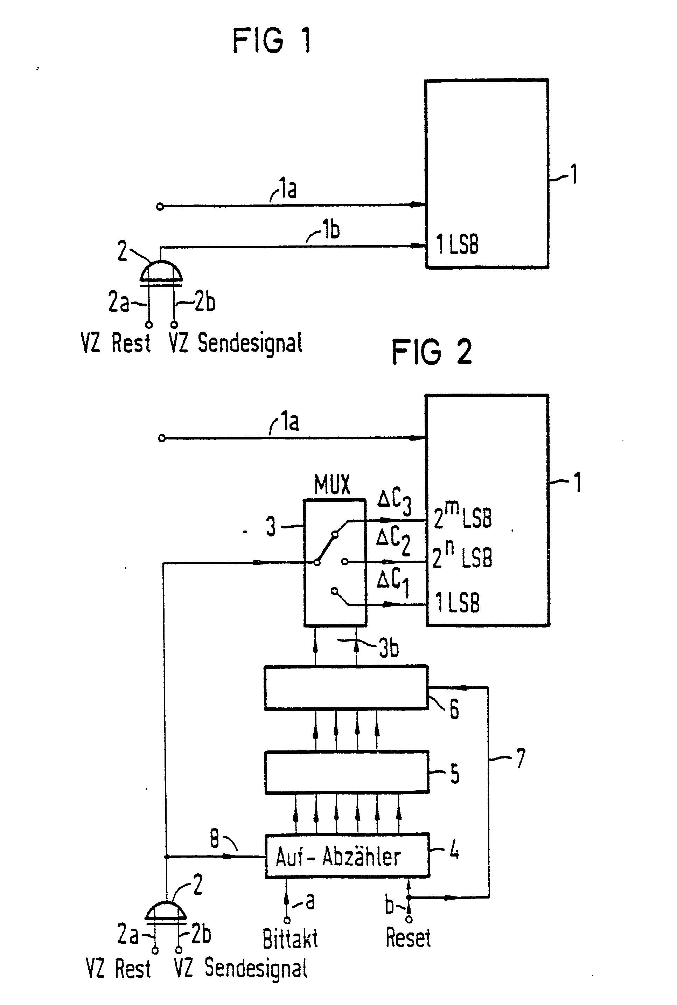

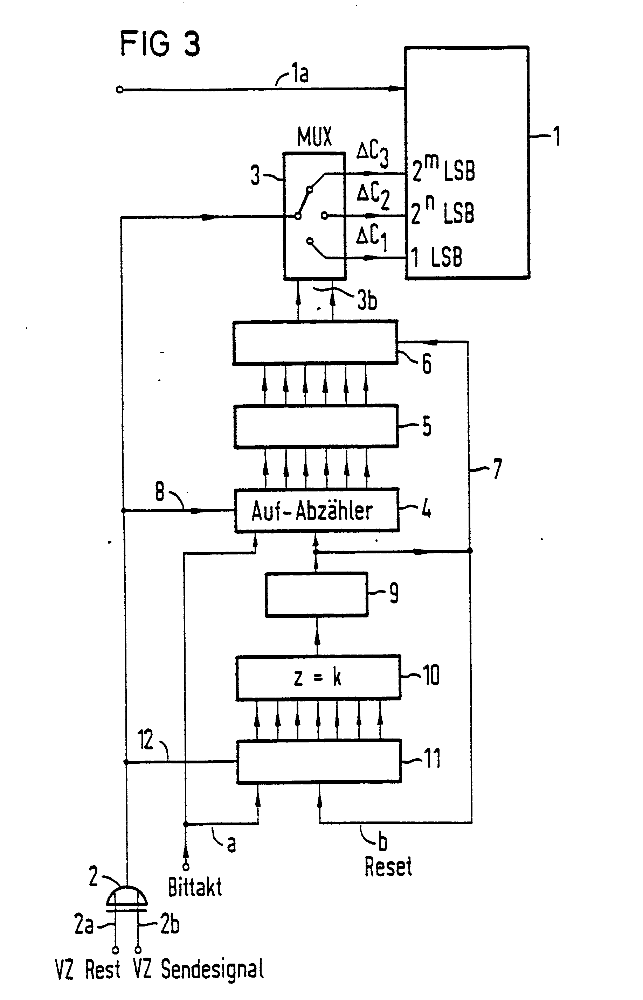

Zur besseren Übersicht ist in der Fig. 1 nochmals der an sich bekannte Stand der Technik gezeigt. Es sei ferner darauf hingewiesen, daß in den Figuren 2 und 3 funktionsgleiche Elemente mit den gleichen Bezugsziffern wie in Fig. 1 versehen sind, so daß insoweit im einzelnen nicht mehr darauf eingegangen werden muß. Fig. 1 läßt also eine Schaltungsanordnung 1 erkennen, in der die Koeffizientenverstellung mit dem LSB (Least significant bit) erfolgt, so daß also dort unmittelbar ein « LSB » erkennbar ist. Die Schaltung 1 hat weiterhin einen Eingang 1a, an dem eine Steuerung in der Weise durchgeführt wird, daß ein Sperren immer dann erfolgt, wenn keine Korrektur erforderlich, d. h. also, wenn beispielsweise das Sendesignal Null ist. Die Korrektur erfolgt am Eingang 1b, an dem das feste Inkrement $\Delta C_v$ zugeführt wird. Das Inkrement $\Delta C_v$ kommt vom Ausgang eines EXOR-Gatters 2, dessen Eingänge mit 2a und 2b bezeichnet sind. Am Eingang 2a dieses EXOR-Gatters 2 liegt dabei ein Signal « VZ Rest », am Eingang 2b liegt das Signal « VZ Sendesignal », also an beiden Eingängen jeweils die Vorzeicheninformationen, aus denen die Richtung der Korrektur abgeleitet wird.

Mit relativ geringem Zusatzaufwand, auch vollständig digital realisierbar, also integrationsfreundlich, kann die Schaltung zur Realisierung des Vorzeichenalgorithmus in Fig. 1 so modifiziert werden, daß abhängig von der Zahl der aufgelaufenen Korrekturen in die gleiche Richtung

a) innerhalb einer festen Auswertezeit von $T = k \cdot T_{Bit}$ (Fig. 2)

b) pro k ausgeführten Korrekturen in positiver oder negativer Richtung (Fig. 3) die Größe von $\Delta C_v$ verändert wird.

Die Stufung der $\Delta C_v$ erfolgt zweckmäßig in ganzzahligen Zweierpotenzen des niederwertigsten bit (LSB), um die unterschiedlichen Gewichte bei digitaler Realisierung besonders einfach durch Eintreten an verschiedenen Bitpositionen realisieren zu können.

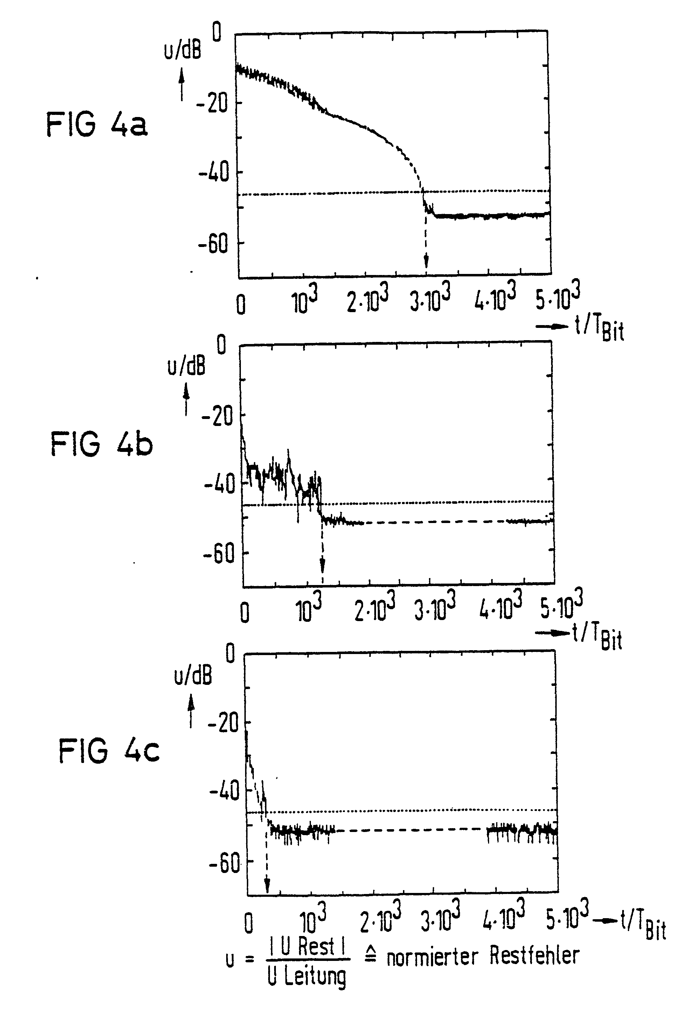

Fig. 4 zeigt die Ergebnisse der Rechnersimulation (u in dB) eines Echokompensators für den Vorzeichenalgorithmus (Fig. 4a), die Umschaltung der $\Delta C_v$ bei $T = 32\ T_{Bit}$ (Fig. 4b) und die Umschaltung bei k = 32 Korrekturen (Fig. 4c).

Es werden jeweils 8 Koeffizienten bei 2 Abtastwerten pro $T_{Bit}$ betrachtet und die $\Delta C_v$ werden im Beispiel wie folgt verändert. Falls innerhalb eines Auswertezyklus

$0 \leqslant n \leqslant 4$ Korrekturen in die gleiche Richtung wirken, gilt $\Delta C_{v1} = 2^{-11}$

$4\ n \leqslant 16$ Korrekturen in die gleiche Richtung wirken, gilt $\Delta C_{v2} = 2^{-9}$

$n > 16$ Korrekturen in die gleiche Richtung wirken, gilt $\Delta C_{v3} = 2^{-5}$.

Die Maximalwerte aller Koeffizienten betragen dabei 1.

Zur Darstellung der $C_v$ werden hierbei 11 Bit + VZ, für die Akkumulation 9 Bit + VZ sowie für die D/A-Wandlung 7 Bit + VZ verwendet.

Ohne Signal der Gegenstation ergibt sich eine Einlaufzeit von 1.) ca. 3000 $T_{Bit}$, 2.) ca. 1250 $T_{Bit}$ und 3. ca. 300 $T_{Bit}$, wenn man von einer Maximalechoamplitude von − 10 dB ausgeht und die Zeit auswertet, bei der letztmalig der theoretische obere Grenzwert des Fehlersignals unterschritten wird.

Bei Anwesenheit eines Signals der Gegenstation ergibt sich für alle Verfahren eine längere Einlaufzeit, doch bleibt das Zeitverhältnis etwa gleich, d. h. der Vorteil des Zeitgewinns bleibt erhalten.

Bei den angegebenen Schaltungen finden Modifikationen des Vorzeichenalgorithmus Verwendung. Insbesondere wird aber in Abhängigkeit von der Zahl der Korrekturen in einem Auswertezyklus die Größe des Korrekturinkrementes $\Delta C_v$ variiert. Gemäß Fig. 2 wird ein Verfahren verwendet, bei dem der Auswertezyklus durch eine feste Zeit $T = k \cdot T_{Bit}$ bestimmt wird, gemäß Fig. 3 wird ein Verfahren angegeben, bei dem der Auswertezyklus durch eine festgelegte Anzahl k von Korrekturen bestimmt wird.

In Fig. 2 ist wieder der Blockbaustein 1 zu erkennen, in dem die Koeffizientenverstellung mit Vielfachen des LSB vorgenommen wird. Für die Vielfachen werden zweckmäßig ganzzahlige Zweierpotenzen des niederwertigsten bit (z. B. 1, $2^n$, $2^m$ m > n) gewählt. Der Eingang 1a dient auch hier zum Sperren der Koeffizientenverstellung, wenn keine Korrektur erforderlich ist, d. h.

also wenn das Sendesignal oder das Restsignal gleich Null ist. Den einzelnen Eingängen vorgeschaltet ist eine Multiplexerschaltung 3, die ergänzend noch mit « MUX » bezeichnet ist. Der eine Eingang der Multiplexerschaltung 3 steht direkt in Verbindung mit dem EXOR-Gatter 2, an dessen Eingängen 2a bzw. 2b wiederum die Vorzeicheninformation «VZ Rest» bzw. « VZ Sendesignal » anliegen. Die Multiplexerschaltung 3 wird an ihren Auswahleingängen 3b durch einen Zwischenspeicher 6 angesteuert. Vorgeschaltet ist ein Zählerstanddecoder 5, der den Zählerstand eines Auf- und Abzählers 4 decodiert. Dieser Auf- und Abzähler 4 hat auch einen Takteingang a, an dem der Bittakt anliegt. Weiterhin ist ein Rücksetzeingang b zu erkennen, über den periodisch einmal pro k $T_{Bit}$ der Zähler auf Auf- und Abzählerstand Null zurückgesetzt wird. Der periodische Rücksetzimpuls b wird über die Leitung 7 dem Zwischenspeicher 6 als Taktimpuls zugeführt. Schließlich ist zu erkennen, daß der Ausgang des EXOR-Gatters 2 über die Leitung 8 mit dem Auf-Abzähler 4 verbunden ist. Im Auf-Abzähler 4 wird die Summe der Korrekturen im aktuellen Auswertezyklus registriert.

Der Auswertezyklus ist bei der Schaltung von Fig. 2 durch eine feste Zeit $T = k \cdot T_{Bit}$ bestimmt. Die Größe des variablen Korrekturinkrementes $\Delta C_v$ ist dabei am Ausgang der Multiplexerschaltung 3 als $\Delta C_1$, $\Delta C_2$ und $\Delta C_3$ symbolisch dargestellt.

Wie die Schaltung von Fig. 2 ist auch die Schaltung von Fig. 3 zur adaptiven Einstellung der $\Delta C$ für einen Koeffizienten dargestellt, wobei in der Schaltung von Fig. 3 ein Auswertezyklus durch k durchgeführte Korrekturen bestimmt ist. Ein Vergleich der beiden Figuren 2 und 3 zeigt unmittelbar, daß die Schaltungen in vielen Teilen übereinstimmen. Auch in der Schaltung von Fig. 3 wird die Summe der Korrekturen in einem Auf-Abzähler 4 vorgenommen, der ebenfalls über einen Impuls vom Rücksetzeingang gesteuert wird. Ebenso wird der Auf-Abzähler 4 auch vom Bittakt vom Anschluß a gesteuert. Dem Auf-Abzähler 4 vorgeschaltet sind ein weiterer Zwischenspeicher 9, mit einem vorgeschalteten Zählstanddecoder 10, der den Zählerstand eines Binärzählers 11 decodiert. Der Binärzähler 11 registriert die Anzahl der Korrekturen, und wenn sein Zählerstand z den Wert k erreicht, gibt der Zählstanddecoder 10 einen Rücksetzimpuls an den Zwischenspeicher 9 ab, da dann ein Auswertezyklus abgeschlossen ist. Dieses Rücksetzsignal gelangt an eine Eingangsklemme b des Binärzählers 11, und der Bittakt an den anderen Takteingang a des Binärzählers 11. Dieser Bittakt muß entsprechend Fig. 2 auch noch dem U/D-Zähler 4 zugeführt werden. Erkennbar ist ferner eine Leitung 12, die am Ausgang des EXOR-Gatters 2 liegt und die einen Freigabeeingang 12 des Binärzählers 11 ansteuert, über den der Zählvorgang freigegeben oder gesperrt werden kann.

Die Schaltung von Fig. 3 realisiert einen Auswertezyklus, der durch eine vorgegebene Zahl von Korrekturen bestimmt wird. Abhängig von der in diesem Zyklus auflaufenden Korrektursumme wird die Größe des Korrekturinkrementes $\Delta C_\nu$ variiert.

Mit den Schaltungen von Fig. 2 und 3 lassen sich die in Fig. 4 dargestellten Wirkungen erreichen. Einzelheiten hierüber sind bereits vorstehend angegeben.

Wie bereits erwähnt, haben das beschriebene Verfahren und die beschriebenen Schaltungen den Vorteil, daß sich mit relativ einfachen schaltungstechnischen Maßnehmen die Koeffizienten bei adaptiven Transversalfiltern in einer beschleunigten Weise einstellen lassen, ohne daß es gegenüber den bekannten Schaltungen eines übermäßigen schaltungstechnischen Aufwandes bedarf.

### Patentansprüche

1. Verfahren zur Einstellung der Koeffizienten eines adaptiven Transversalfilters (durchzuführende Korrekturen) durch Modifikation des Vorzeichenalgorithmus, dadurch gekennzeichnet, daß in Abhängigkeit von der Zahl der Korrekturen in einem Auswertezyklus die Größe des Korrekturinkrementes ($\Delta C_\nu$) variiert wird.

2. Verfahren nach Anspruch 1, dadurch gekennzeichnet, daß der Auswertezyklus durch eine feste Zeit (T = k · $T_{Bit}$) bestimmt wird (Fig. 2).

3. Verfahren nach Anspruch 1, dadurch gekennzeichnet, daß der Auswertezyklus durch eine festgelegte Anzahl (k) von Korrekturen bestimmt wird (Fig. 3).

4. Schaltungsanordnung zur Durchführung des Verfahrens nach Anspruch 2, dadurch gekennzeichnet, daß eines Koeffizienten-Verstellschaltung (1) ein Multiplexer (3) mit mehreren Ausgängen ($\Delta C_\nu$) vorgeschaltet ist, der über ein EXOR-Gatter (2) angesteuert ist und dessen Auswahleingängen (3b) ein Auf-Abzähler (4), ein Zählstanddecoder (5) und ein Zwischenspeicher (6) vorgeschaltet sind, daß der Ausgang des EXOR-Gatters (2) einen Steuereingang (8) des Auf-Abzählers (4) bildet, von dem ein weiterer Eingang (a) mit dem Bittakt beaufschlagt ist, und daß an einem weiteren, mit einem Eingang des Zwischenspeichers (6) verbundenen (7) Eingang (b) des Auf-Abzählers (4) ein periodischer Rücksetztakt anliegt.

5. Schaltungsanordnung zur Durchführung des Verfahrens nach Anspruch 3, dadurch gekennzeichnet, daß eine Koeffizienten-Verstellschaltung (1) ein Multiplexer (3) mit mehreren Ausgängen ($\Delta C_\nu$) vorgeschaltet ist, das über ein EXOR-Gatter (2) angesteuert ist und dessen Auswahleingängen (3b) ein Auf-Abzähler (4), ein Zählstanddecoder (5) und ein Zwischenspeicher (6) vorgeschaltet sind, daß der Ausgang des EXOR-Gatters (2) einen Steuereingang (8) des Auf-Abzählers (4) bildet, von dem ein weiterer Eingang (a) mit dem Bittakt beaufschlagt ist, und daß an einem weiteren, mit einem Eingang des Zwischenspeichers (6) verbundenen (7) Eingang (b) des Auf-Abzählers (4) ein Rücksetzimpuls anliegt, der abgegeben wird, wenn die Anzahl der Korrekturen den festgelegten Wert k erreicht hat, und daß weiterhin dem Auf-Abzähler (4) ein Binärzähler (11), ein Zählerstandsdecoder (10) und ein weiterer Zwischenspeicher (9) vorgeschaltet sind, und daß der Ausgang des EXOR-Gatters (2) mit einem Eingang des Binärzählers (11) verbunden (12) ist, dessen weitere Eingänge (a bzw. b) mit dem Bittakt bzw. mit dem Rücksetzimpuls beaufschlagt werden.

### Claims

1. Coefficient adjusting method for an adaptive transversal filter (corrections to be performed) by modification of the sign algorithm, characterized in that the magnitude of the correction increment ($\Delta C_\nu$) is varied in dependence on the number of corrections in an evaluating cycle.

2. Method according to Claim 1, characterized in that the evaluating cycle is determined by a fixed time (T = k · $T_{Bit}$) (Figure 2).

3. Method according to Claim 1 characterized in that the evaluating cycle is determined by a fixed number (k) of corrections (Figure 3).

4. Circuit arrangement for carrying out the method according to Claim 2, characterized in that a coefficient adjusting circuit (1) is preceded by a multiplexer (3) having several outputs ($\Delta C_\nu$), which is driven via an EXOR gate (2) and the selection inputs (3b) of which are preceded by an up/down counter (4), a count decoder (5) and a buffer store (6), in that the output of the EXOR gate (2) forms a control input (8) of the up/down counter (4) to a further input (a) of which the bit clock is applied, and in that a periodic reset clock is present at a further input (b), which is connected to an input of the buffer store (6), of the up/down counter (4).

5. Circuit arrangement for carrying out the method according to Claim 3, characterized in that a coefficient adjusting circuit (1) is preceded by a multiplexer (3) which has several outputs ($\Delta C_\nu$), which is driven via an EXOR gate (2), and the selection inputs (3b) of which are preceded by an up/down counter (4), a count decoder (5), and a buffer store (6), in that the output of the EXOR gate (2) forms a control input (8) of the up/down counter (4) to a further input (a) of which the bit clock is applied, and in that a reset pulse, which is emitted when the number of corrections has reached the predetermined value k, is present at a further input (b), which is connected to (7) to an input of the buffer store (6), of the up/down counter (4), and in that furthermore the up/down counter (4) is preceded by a binary counter (11), a count decoder (10) and a further buffer store (9), and in that the output of the EXOR gate (2) is connected (12) to an input of the binary counter (11), to the further inputs (a and b, respectively) of which the bit clock and the reset pulse, respectively, are applied.

### Revendications

1. Procédé pour régler les coefficients d'un filtre transversal adaptatif (corrections devant être exécutées) par modification de l'algorithme du signe, caractérisé par le fait que la grandeur de l'incrément de correction ($\Delta C_\nu$) est modifiée en fonction du nombre des corrections dans un cycle d'évaluation.

2. Procédé suivant la revendication 1, caractérisé par le fait que le cycle d'évaluation est déterminé par une durée fixe ($T = k \cdot T_{bit}$) (figure 2).

3. Procédé suivant la revendication 1, caractérisé par le fait que le cycle d'évaluation est déterminé par un nombre fixé (k) de corrections (figure 3).

4. Montage pour la mise en œuvre du procédé suivant la revendication 2, caractérisé par le fait qu'en amont d'un circuit (1) de réglage des coefficients est branché un multiplexeur (3), qui comporte plusieurs sorties ($\Delta C_\nu$) et est commandé par l'intermédiaire d'une porte OU-Exclusif (2) et en amont des entrées de sélection (3b) duquel sont branchés un compteur progressif/régressif (4), un décodeur (5) de l'état de comptage et une mémoire intermédiaire (6), que la sortie de la porte OU-Exclusif (2) forme une entrée de commande (8) du compteur progressif/régressif (4), par laquelle une autre entrée (a) est chargée par la cadence binaire, et qu'une cadence périodique de remise à l'état initial est appliquée à une autre entrée (b) du compteur progressif/régressif (4), reliée à une entrée de la mémoire intermédiaire (6).

5. Montage pour la mise en œuvre du procédé selon la revendication 3, caractérisé par le fait qu'en amont d'un circuit (1) de réglage des coefficients est branché un multiplexeur (3), qui comporte plusieurs sorties ($\Delta C_\nu$) et est commandé par l'intermédiaire d'une porte OU-Exclusif (2) et en amont des entrées de sélection (3b) duquel sont branchés un compteur progressif/régressif (4), un décodeur (5) de l'état de comptage et une mémoire intermédiaire (6) que la sortie de la porte OU-Exclusif (2) forme une entrée de commande (8) du compteur progressif/régressif (4), par laquelle une autre entrée (a) est chargée par la cadence binaire, et qu'une impulsion périodique de remise à l'état initial est appliquée à une autre entrée (b) du compteur progressif/régressif (4), reliée (7) à une entrée de la mémoire intermédiaire (6), impulsion délivrée lorsque le nombre des corrections a atteint la valeur fixée k et qu'un compteur binaire (11), un décodeur (10) de l'état de comptage et une autre mémoire intermédiaire (9) sont en outre branchés en amont du compteur progressif/régressif (4), et que la sortie de la porte OU-Exclusif (2) est reliée (12) à une entrée du compteur binaire (11), dont les autres entrées (a ou b) sont chargées par la cadence binaire ou par l'impulsion de remise à l'état initial.

# FIG 1

1a

1b

2

1 LSB

1

2a — — 2b

VZ Rest   VZ Sendesignal

# FIG 2

1a

MUX

3

$\Delta C_3$   $2^m$ LSB

$\Delta C_2$   $2^n$ LSB

$\Delta C_1$   1 LSB

1

3b

6

7

5

8

Auf – Abzähler   4

2

2a — — 2b

a

b

VZ Rest   VZ Sendesignal

Bittakt

Reset

# FIG 3

FIG 4a

FIG 4b

FIG 4c

$$u = \frac{|\,U\,Rest\,|}{U\,Leitung} \;\hat{=}\; \text{normierter Restfehler}$$